**Europäisches Patentamt**

**European Patent Office**

**Office européen des brevets**

(11) Veröffentlichungsnummer: **0 415 187 B1**

(12) **EUROPÄISCHE PATENTSCHRIFT**

(45) Veröffentlichungstag der Patentschrift: **03.08.94**

(51) Int. Cl.5: **G03F 7/033**

(21) Anmeldenummer: **90115665.3**

(22) Anmeldetag: **16.08.90**

(54) **Wasserlösliches oder -dispergierbares photopolymerisierbares Gemisch und seine Verwendung zu Druckzwecken.**

(30) Priorität: **26.08.89 DE 3928289**

(43) Veröffentlichungstag der Anmeldung:
**06.03.91 Patentblatt 91/10**

(45) Bekanntmachung des Hinweises auf die
Patenterteilung:
**03.08.94 Patentblatt 94/31**

(84) Benannte Vertragsstaaten:
**BE DE DK ES FR GB IT NL SE**

(56) Entgegenhaltungen:
**EP-A- 0 010 690**
**EP-A- 0 266 069**
**EP-A- 0 295 545**

(73) Patentinhaber: **BASF Aktiengesellschaft**
**Carl-Bosch-Strasse 38**
**D-67063 Ludwigshafen(DE)**

(72) Erfinder: **Littmann, Dieter, Dr.**
**Neckarpromenade 36**
**D-6800 Mannheim 1(DE)**

Rank Xerox (UK) Business Services
(3.10/3.09/3.3.3)

**Beschreibung**

Die vorliegende Erfindung betrifft ein neues wasserlösliches oder -dispergierbares photopolymerisierbares Gemisch, welches - kurz gesagt - mindestens zwei stofflich unterschiedliche Polyvinylalkoholharze (A), mindestens ein wasserlösliches monofunktionelles ethylenisch ungesättigtes photopolymerisierbares Monomeres (B), mindestens ein polyfunktionelles ethylenisch ungesättigtes photopolymerisierbares Monomeres (C) und mindestens einen Photopolymerisationsinitiator (D) enthält.

Photopolymerisierbare Gemische dieser Art sind bekannt. Sie dienen vor allem der Herstellung der photopolymerisierbaren Aufzeichnungsschichten von lichtempfindlichen Aufzeichnungselementen, welche nach ihrer bildmäßigen Belichtung mit aktinischem Licht und ihrer Entwicklung mit Wasser als Hochdruckplatten, insbesondere für den Zeitungsdruck, verwendet werden.

So geht beispielsweise aus der EP-A-0 266 069 ein photopolymerisierbares Gemisch hervor, welches, bezogen auf seine Gesamtmenge, 35 bis 41 Gew.-% mindestens eines wasserlöslichen monofunktionellen ethylenisch ungesättigten photopolymerisierbaren Monomeren, 6,5 bis 8,5 Gew.-% mindestens eines polyfunktionellen ethylenisch ungesättigten photopolymerisierbaren Monomeren und 47,5 bis 63, insbesondere 49 bis 52 Gew.-%, mindestens eines partiell verseiften Poly(vinylalkohol-alkancarbonsäureesters) enthält. Hierbei soll der partiell verseifte Poly(vinylalkohol-alkancarbonsäureester) einen Polymerisationsgrad P von 200 bis 400 aufweisen, wobei nicht angegeben wird, ob es sich bei dem Polymerisationsgrad P um den Zahlenmittleren ($\overline{P}_n$) oder den massenmittleren ($\overline{P}_w$) handelt. Des weiteren kann der vorstehend genannte partiell verseifte Poly(vinylalkohol-alkancarbonsäureester) zusammen mit einer geringeren Menge eines partiell verseiften Poly(vinylalkohol-alkancarbonsäureesters) des Polymerisationsgrades P von 500 verwendet werden, wobei das Gewichtsverhältnis vorzugsweise bei 3:1 liegt. Außerdem soll der mittlere Verseifungsgrad dieser Polyvinylalkoholharze in etwa 78 bis 84 % der ursprünglich vorhandenen Alkancarbonsäureestergruppen betragen, wobei die einzelnen Polyvinylalkoholharze einen Verseifungsgrad von 65 bis 90 % haben können.

Wird dieses bekannte photopolymerisierbare Gemisch als photopolymerisierbare Aufzeichnungsschicht in einem lichtempfindlichen Aufzeichnungselement verwendet, dann soll es die Verarbeitungseigenschaften des lichtempfindlichen Aufzeichnungselements verbessern und letztlich zu besseren Drucken führen. Die lichtempfindliche Aufzeichnungselemente sollen sich rascher mit aktinischem Licht belichten und hiernach schneller auswaschen lassen als andere bereits bekannte lichtempfindliche Aufzeichnungselemente, wobei die Verbesserung bei 10 bis 15 % liegen soll. Außerdem soll sich die Lichtempfindlichkeit der photopolymerisierbaren Aufzeichnungsschichten durch die Mitverwendung einer Trägerschicht, welche UV-Licht stark reflektiert, noch weiter steigern lassen. Des weiteren sollen die aus den lichtempfindlichen Aufzeichnungselementen hergestellten Hochdruckplatten Druckfarben besser und schneller übertragen.

Ein weiteres photopolymerisierbares Gemisch der eingangs genannten Art geht aus der US-A-4 272 611 hervor. Hierin wird als Bindemittel ein Gemisch aus partiell verseiften Poly(vinylalkohol-alkancarbonsäureestern) eines Polymerisationsgrades P von 200 bis 3000, insbesondere 250 bis 700, und eines Verseifungsgrades von 65 bis 100, insbesondere 80 bis 88 %, und einem partiell verseiften Pfropfmischpolymerisat aus Vinylalkohol-alkancarbonsäureestern und Alkylenoxiden verwendet. Dieses Pfropfmischpolymerisat kann einen Gehalt an Alkylenoxid-Einheiten von 5 bis 75 Gew.-%, einen Verseifungsgrad von 70 bis 100 % und ein Molekulargewicht von 5000 bis $2 \cdot 10^5$ aufweisen, wobei speziell Pfropfmischpolymerisate mit einem Gehalt an Alkylenoxid-Einheiten von 24 Gew.-%, einem Verseifungsgrad von 85 % und einem Molekulargewicht von 30.000 bis 35.000 oder mit einem Gehalt an Alkylenoxideinheiten von 54 Gew.-%, einem Verseifungsgrad von 83 mol-% und einem Molekulargewicht von 35.000 bis 50.000 oder mit einem massenmittleren Polymerisationsgrad $\overline{P}_w$ von 460 genannt werden. Diese speziell genannten Pfropfmischpolymerisate werden vor allem zusammen mit einem partiell verseiften Poly(vinylalkohol-alkancarbonsäureester) eines Polymerisationsgrades P von 500 angewendet.

Auch durch die Verwendung dieses bekannten photopolymerisierbaren Gemischs soll sich die Herstellung lichtempfindlicher Aufzeichnungselemente vereinfachen, weil das photopolymerisierbare Gemisch die Herstellung klarer homogener Lösungen gestattet und weder bei seiner Abformung noch bei seiner Trocknung und Lagerung eine Phasentrennung und ein Ausschwitzen von Mischungsbestandteilen zeigt. Die mit Hilfe dieses photopolymerisierbaren Gemischs hergestellten photopolymerisierbaren Aufzeichnungsschichten sollen nicht klebrig sein, so daß hierauf aufgelegte Negativ-Vorlagen Zu keiner Schädigung mehr führen sollen. Außerdem soll die Auswaschzeit nach der bildmäßigen Belichtung mit aktinischem Licht kürzer sein als bei anderen bekannten photopolymerisierbaren Aufzeichnungsschichten bzw. anderen bekannten lichtempfindlichen Aufzeichnungselemente. Des weiteren sollen die lichtempfindlichen Aufzeichnungselemente der US-A-4 272 611 Hochdruckplatten liefern, welche eine geringere Feuchtigkeitsempfindlichkeit und Sprödigkeit und verbesserte Farbübertragungseigenschaften aufweisen.

Ein weiteres photopolymerisierbares Gemisch der eingangs genannten Art ist aus der DE-A-37 38 215 bekannt. Dieses bekannte photopolymerisierbare Gemisch enthält als Bindemittel einen partiell verseiften Poly(vinylalkohol-alkancarbonsäureester) mit einem Verseifungsgrad von 65 bis 90 mol-% und einem Polymerisationsgrad P von 50 bis 2000, insbesondere 200 bis 1000, und einen partiell verseiften poly-(vinylalkohol-alkancarbonsäureester) mit einem Verseifungsgrad von weniger als 65 % und einem Polymerisationsgrad von nicht mehr als 2000, insbesondere nicht mehr als 500. Das letztgenannte Polyvinylalkoholharz kann außerdem ionische Gruppen, insbesondere anionische Gruppen wie Sulfonsäurealkalimetallsalzgruppen enthalten. Die beiden Polyvinylalkoholharze werden in Mengenverhältnissen von 50:50 bis 98:2 angewendet.

Dieses bekannte photopolymerisierbare Gemisch soll sich in besonders hoher Konzentration in Wasser auflösen lassen. Die photopolymerisierbaren Aufzeichnungsschichten aus diesem bekannten photopolymerisierbaren Gemisch sollen eine verbesserte Flexibilität aufweisen. Außerdem soll eine deutlich verbesserte Auflösungsrate erzielt werden, so daß Hochdruckplatten wirksamer hergestellt werden können.

Noch ein weiteres Beispiel für ein photopolymerisierbares Gemisch der eingangs genannten Art wird in der US-A-3 801 328 beschrieben. Dieses bekannte photopolymerisierbare Gemisch enthält einen partiell verseiften Poly(vinylalkohol-alkancarbonsäureester) eines mittleren Polymerisationsgrades P von 500 und eines Verseifungsgrades von 80,5 % und einen partiell verseiften Poly(vinylalkohol-alkancarbonsäureester) des mittleren Polymerisationsgrades P von 500 und eines Verseifungsgrades von 88,5 %. Mit Hilfe dieses bekannten photopolymerisierbaren Gemisches sollen sich harte und haltbare Hochdruckplatten herstellen lassen, wobei die für die Herstellung dieser Hochdruckplatten verwendeten lichtempfindlichen Aufzeichnungselemente ohne Lichthofschutzmittel und Haftschichten auskommen sollen.

Aus der EP-A-0 295 545 geht ferner ein photopolymerisierbares Gemisch hervor, welches der Herstellung von durch Photopolymerisation vernetzbaren Heißprägeplatten und Heißprägematrizen hieraus dient. Das bekannte photopolymerisierbare Gemisch enthält als Bindemittel mindestens einen partiell oder nahezu vollständig verseiften Poly(vinylalkohol-alkancarbonsäureester) in Kombination mit mindestens einem Alkencarbonsäureester und/oder Alkencarbonylamino-N-methylenether von partiell oder nahezu vollständig verseiften Poly(vinylalkohol-alkancarbonsäureestern) und/oder Alkencarbonsäureester und/oder Alkencarbonylamino-N-methylenether von partiell oder nahezu vollständig verseiften Pfropfmischpolymerisaten aus Vinylalkohol-alkancarbonsäureestern und Alkylenoxiden. Speziell werden Bindemittelgemische aus partiell verseiftem Polyvinylacetat eines Verseifungsgrades von 80 % und eines zahlenmittleren Molgewichts $\overline{M}_n$ von $2 \cdot 10^4$, was einem zahlenmittleren Polymerisationsgrad $\overline{P}_n$ von etwa 400 entspricht, und (i) Acrylsäureestern von partiell verseiftem Polyvinylacetat eines Hydrolysegrades von 82 % und einem zahlenmittleren Molekulargewicht $\overline{M}_n$ von $2 \cdot 10^4$, (ii) Acrylsäureestern eines partiell verseiften Ethylenoxid-Vinylacetat-Pfropfmischpolymerisats eines zahlenmittleren Molekulargewichts $\overline{M}_n$ von $2 \cdot 10^4$ und eines Gehalts an Ethylenoxid-Einheiten von 25 Gew.-%, (iii) Acrylamido-N-methylenethern eines partiell verseiften Polyvinylacetats des Verseifungsgrades von 82 % und des zahlenmittleren Molekulargewichts $\overline{M}_n$ von $2 \cdot 10^4$ oder (iv) Acrylamido-N-methylenethern des vorstehend genannten Pfropfmischpolymerisats verwendet. In der Patentschrift wird empfohlen, diese Bindemittel in Verbindung mit mindestens einem Alkencarbonylamino-N-methylenether eines mehrwertigen Alkohols als polyfunktionellem ethylenisch ungesättigtem photopolymerisierbarem Monomer zu verwenden.

Die mit Hilfe dieses bekannten photopolymerisierbaren Gemischs hergestellten Heißprägeplatten sollen als solche bereits eine hohe thermische Stabilität aufweisen und lagerstabil sein, wobei sie sich auch umweltfreundlich entsorgen lassen sollen. Sie sollen außerdem kürzere Belichtungs- und Entwicklungszeiten aufweisen als andere bekannte photopolymerisierbare Gemische, so daß insgesamt kürzere Verfahrenszeiten und somit höhere Raum/Zeit-Ausbeuten bei der Herstellung von Heißprägematrizen resultieren. Darüber hinaus sollen die Trocknungszeiten für die Heißprägematricen verkürzt werden können, weil deren anwendungstechnisches Eigenschaftsprofil durch einen vergleichsweise hohen Restwassergehalt nicht verschlechtert werden soll. Überdies sollen ihre Reliefschichten so hart, temperaturbeständig und dimensionsstabil sein, daß sie selbst nach 10facher Verwendung zum Heißprägen keine nachteiligen Veränderungen erleiden.

Ferner geht aus der EP-A-0 295 547 ein photopolymerisierbares Gemisch der eingangs genannten Art hervor, welches als Bindemittel ein Gemisch aus einem Methacrylsäureester eines partiell verseiften Poly-(vinylalkohol-alkancarbonsäureesters) eines Verseifungsgrades von 80 % und eines Zahlenmittleren Molekulargewichts $\overline{M}_n$ von $2,5 \cdot 10^4$ und einem partiell verseiften Poly(vinylalkohol-alkancarbonsäureester) eines Hydrolysegrades von 80 mol-% und eines zahlenmittleren Molekulargewichts $\overline{M}_n$ von $2,5 \cdot 10^4$ enthält. Neben den photopolymerisierbaren Monomeren, und dem Photopolymerisationsinitiator enthält dieses bekannte photopolymerisierbare Gemisch noch Glyoxal. Mit Hilfe dieser Verbindung soll erreicht werden, daß die Hochdruckplatten, welche aus lichtempfindlichen Aufzeichnungselementen hergestellt werden, die photopolymerisierbare Aufzeichnungsschichten und/oder Haftschichten aus diesem bekannten photopolymerisierten Gemisch enthalten, eine bessere Bildwiedergabe zeigen, eine hohe Härte, eine sehr geringe Wasserempfindlichkeit und eine vorzügliche Farbannahme haben sowie keine Quellschäden und keinen Lochfraß mehr aufweisen.

Demnach muß man nach wie vor jeweils ein spezielles photopolymerisierbares Gemisch der eingangs genannten Art bereitstellen, wenn man eines der vorstehend aufgeführten Eigenschaftsprofile bzw. einen der genannten technischen Effekte realisieren will, weil keines der bekannten photopolymerisierbaren Gemische dazu geeignet ist, alle Anforderungen der Praxis in vollem Umfang zu erfüllen. Die Notwendigkeit, für jeden Anwendungszweck ein spezielles photopolymerisierbares Gemisch bereitzustellen, ist ein schwerwiegender Nachteil, erfordert dies doch einen hohen präparativen Aufwand für die Herstellung der einzelnen Komponenten und erzwingt dies doch häufig apparative Veränderungen an den Anlagen zur Herstellung der photopolymerisierbaren Gemische, der photopolymerisierbaren Aufzeichnungsschichten, der lichtempfindlichen Aufzeichnungselemente und der Hochdruckplatten beim Produzenten und im Druckereibetrieb.

Will man dagegen ein bereits bekanntes photopolymerisierbares Gemisch optimieren, um es weiteren Anwendungszwecken zuzuführen, ergeben sich neue Probleme. So weisen photopolymerisierbare Gemische, welche eine höhere Gießkonzentration bei der Herstellung der lichtempfindlichen Aufzeichnungselemente gestatten und damit wirtschaftlich attraktiver sind und zu kürzeren Entwicklungs- und Trocknungszeiten bei der Hochdruckplattenherstellung führen, im photopolymerisierten Zustand eine höhere Sprödigkeit und Brüchigkeit auf. Des weiteren ist oftmals die Kohäsion der betreffenden photopolymerisierbaren Aufzeichnungsschicht verringert, so daß es zur Rißbildung kommt. Dem Nachteil der höheren Neigung zum Verspröden könnte man beispielsweise durch Zugabe von Weichmachern entgegenwirken. Indes führt diese Maßnahme zu anderen sattsam bekannten Problemen wie z.B. der Verringerung der gegenseitigen Verträglichkeit der Bestandteile des photopolymerisierbaren Gemisches, welche zum Ausschwitzen von photopolymerisierbaren Monomeren, Weichmachern und anderen niedermolekularen Bestandteilen sowie zu Trübungen führt.

Somit gelingt es nicht, auf der Grundlage der bisher bekannten photopolymerisierbaren Gemische bzw. der darin enthaltenen Bindemittelkombinationen ein Eigenschaftsprofil zu erzeugen, welches die Vorteile einer hohen Feststoffkonzentration in Lösung und einer stark verkürzten Auswasch- und Trocknungszeit bei der Druckplattenherstellung umfaßt, ohne sich hierbei die Nachteile wie eine hohe Sprödigkeit und eine geringe Kohäsion der photopolymerisierbaren Aufzeichnungsschicht einzuhandeln. Noch weniger gelingt es, die bisher bekannten photopolymerisierbaren Gemische so zu variieren, daß die Verträglichkeit der darin enthaltenen Bestandteile, eine hohe Auflösung und ein hoher Belichtungsspielraum bei der bildmäßigen Belichtung, verkürzte Belichtungszeiten und eine geringere Verschmutzung der für die Entwicklung verwendeten Wascher erreicht wird. Demgemäß kann bei den Hochdruckplatten, welche mit Hilfe dieser bekannten lichtempfindlichen Gemische hergestellt wurden, kein Eigenschaftsprofil erzeugt werden, das eine gleichmäßige glatte Oberfläche, eine bessere vollflächige Farbdeckung im Druck, sehr glatte Flanken im Relief, eine geringe Neigung zum Rupfen und zum Zusetzen mit Papierstaub beim Drucken (linting) und eine hohe Auflagenfestigkeit umfaßt.

Aufgabe der vorliegenden Erfindung ist es, ein neues photopolymerisierbares Gemisch bereitzustellen, welches die Nachteile des Standes der Technik nicht mehr länger aufweist und mit dessen Hilfe sich die gewünschten und von der Praxis geforderten Vorteile realisieren lassen.

Überraschenderweise konnte die Aufgabe der vorliegenden Erfindung dadurch gelöst werden, daß man mindestens zwei stofflich unterschiedliche, speziell ausgewählte partiell verseifte Poly(vinylalkohol-alkancarbonsäureester) in bestimmten, genau festgelegten Mengen als Bindemittel für das neue photopolymerisierbare Gemisch verwendet. Zu dieser überraschenden Lösung hat die Auswahl bestimmter, genau festgelegter Mengen an wasserlöslichen monofunktionellen ethylenisch ungesättigten photopolymerisierbaren Monomeren, polyfunktionellen ethylenisch ungesättigten photopolymerisierbaren Monomeren und photopolymerisationsinitiatoren beigetragen.

Im Hinblick auf den Stand der Technik war es überraschend, daß sich mit Hilfe des neuen photopolymerisierbaren Gemischs die gewünschten und von der Praxis geforderten Vorteile realisieren lassen, ohne daß hierbei die Nachteile des Standes der Technik auftreten.

Demnach handelt es sich bei dem Gegenstand der vorliegenden Erfindung um ein wasserlösliches oder -dispergierbares photopolymerisierbares Gemisch, welches, bezogen auf seine Gesamtmenge,

A) 46 bis 53 Gew.-% eines Bindemittels aus, bezogen auf das Bindemittel (A),

$a_1$) 20 bis 80 Gew.-% mindestens eines partiell verseiften Poly(vinylalkohol-alkancarbonsäureesters) mit einem Verseifungsgrad von 75 bis 85 % der ursprünglich vorhandenen Alkancarbonsäureestergruppen und eines zahlenmittleren Polymerisationsgrades $\overline{P}_n$ von 250 bis 350,

$a_2$) 20 bis 80 Gew.-% mindestens eines partiell verseiften Pfropfmischpolymerisats aus Vinylalkohol-alkancarbonsäureestern und Alkylenoxiden mit einem Verseifungsgrad von mehr als 80 % der ursprünglich vorhandenen Alkancarbonsäureestergruppen, einem Gehalt an Alkylenoxid-Einheiten von 10 bis 40 Gew. -% und einem aus dem durch Viskositätsmessungen an verdünnten Lösungen ermittelten massenmittleren Molgewicht $\overline{M}_w$ nach der Gleichung

$$\overline{M}_w = \overline{P}_w \text{ (86 minus 0,42 } \cdot \text{ Verseifungsgrad)}$$

errechneten massenmittleren Polymerisationsgrad $\overline{P}_w$ von 300 bis 500
und
$a_3$) 0 bis 60 Gew.-% mindestens eines partiell verseiften Poly(vinylalkohol-alkancarbonsäureesters) mit einem Verseifungsgrad von mehr als 75 % der ursprünglich vorhandenen Alkancarbonsäureestergruppen und einem zahlenmittleren Polymerisationsgrad $\overline{P}_n$ von 350 bis 450,
B) 35 bis 44 Gew.-% mindestens eines wasserlöslichen monofunktionellen ethylenisch ungesättigten photopolymerisierbaren Monomeren, welches mit dem Bindemittel (A) verträglich ist,
C) 6 bis 9 Gew.-% mindestens eines polyfunktionellen ethylenisch ungesättigten photopolymerisierbaren Monomeren, welches mit dem Bindemittel (A) verträglich ist,
und
D) 0,4 bis 5 Gew.-% mindestens eines Photopolymerisationsinitiators enthält.

Im folgenden wird das neue wasserlösliche oder -dispergierbare photopolymerisierbare Gemisch der Kürze halber als "erfindungsgemäßes Gemisch" bezeichnet.

Der für die Erfindung wesentliche Bestandteil des erfindungsgemäßen Gemisches ist das neuartige Bindemittelgemisch (A). Dieses ist in dem erfindungsgemäßen Gemisch in einer Menge von 46 bis 53 Gew.-% enthalten. Zwar können durchaus noch andere Mengen, beispielsweise im Bereich von 40 bis 46 Gew.-% oder 53 bis 60 Gew.-%, verwendet werden, indes stellen sich dann die besonderen Vorteile des erfindungsgemäßen Gemisches manchmal nicht mehr in der erforderlichen Zuverlässigkeit ein. Demnach handelt es sich bei dem Mengenbereich von 46 bis 53 Gew. -% um ein Optimum, innerhalb dessen die Menge des neuartigen Bindemittelgemischs (A) frei gewählt und dem jeweiligen Verwendungszweck in vorteilhafter Weise angepaßt werden kann. Innerhalb dieses Mengenbereichs ist derjenige von 49 bis 51 Gew.-% besonders hervorzuheben, weil erfindungsgemäße Gemische, welche das neuartige Bindemittelgemisch (A) in diesen Mengen enthalten, ganz besonders vorteilhaft sind und deshalb erfindungsgemäß bevorzugt verwendet werden.

Das neuartige Bindemittelgemisch (A) enthält, bezogen auf seine Gesamtmenge, 20 bis 80 Gew.-% mindestens eines partiell verseiften Poly(vinylalkohol-alkancarbonsäureesters) mit einem Verseifungsgrad von 75 bis 85 % der ursprünglich vorhandenen Alkancarbonsäureestergruppen und einem zahlenmittleren Polymerisationsgrad $\overline{P}_n$ von 250 bis 350 (Bindemittel $a_1$).

Enthält das neuartige Bindemittelgemisch (A) das Bindemittel ($a_1$) in Mengen von kleiner als 20 Gew.-% oder größer als 80 Gew.-%, dann stellen sich die erfindungsgemäß erzielten Vorteile nicht mehr zuverlässig ein. Demnach handelt es sich bei dem Mengenbereich von 20 bis 80 Gew.-% um ein Optimum, innerhalb dessen der Anteil des Bindemittels ($a_1$) an dem neuartigen Bindemittelgemisch (A) frei gewählt und dem jeweiligen Verwendungszweck in hervorragender Weise angepaßt werden kann. Ganz besondere Vorteile resultieren aus der Verwendung einer Menge an Bindemittel ($a_1$), welche in dem Bereich von 25 bis 50 Gew.-% liegt, weil die erfindungsgemäßen Gemische, welche ein neuartiges Bindemittelgemisch (A) eines solchen Anteils an Bindemittel ($a_1$) enthalten, besonders gute anwendungstechnische Eigenschaften haben.

Das Bindemittel ($a_1$) muß erfindungsgemäß einen Verseifungsgrad von 75 bis 85 % der ursprünglich vorhandenen Alkancarbonsäureestergruppen aufweisen. Bindemittel mit höheren oder niedrigeren Verseifungsgraden sind für die Verwendung in dem neuartigen Bindemittelgemisch (A) bzw. in dem erfindungsgemäßen Gemisch nicht geeignet. Erfindungsgemäß ist es von Vorteil, wenn der Verseifungsgrad des Bindemittels ($a_1$) bei 78 bis 83 % liegt.

Das Bindemittel ($a_1$) hat einen zahlenmittleren Polymerisationsgrad $\overline{P}_n$ von 250 bis 350. Bindemittel mit einem höheren oder einem niedrigeren zahlenmittleren Polymerisationsgrad $\overline{P}_n$ sind dagegen für den erfindungsgemäßen Anwendungszweck nicht geeignet, denn sie haben eine Verschlechterung des Eigenschaftsprofils des betreffenden Bindemittelgemischs und damit des betreffenden photopolymerisierbaren Gemischs zur Folge. Demnach handelt es sich bei dem Bereich von 250 bis 350 um ein Optimum, innerhalb dessen der zahlenmittlere Polymerisationsgrad $\overline{P}_n$ frei gewählt und dem jeweiligen Verwendungszweck des erfindungsgemäßen Gemischs hervorragend angepaßt werden kann. Besondere Vorteile für das erfindungsgemäße Gemische ergeben sich, wenn das Bindemittel ($a_1$) einen zahlenmittleren Polymerisa-tionsgrad $\overline{P}_n$ aufweist, welcher bei 300 liegt.

Das Bindemittel (a₁) ist ein Poly(vinylalkohol-alkancarbonsäureester), welcher in der Fachwelt auch als "Polyvinylalkohol" oder "Polyvinylalkoholharz" bezeichnet wird. Für den erfindungsgemäßen Verwendungszweck sind alle Poly(vinylalkohol-alkancarbonsäureester) geeignet, welche sich in einfacher Weise herstellen und gezielt verseifen lassen und hiernach das vorstehend im Detail beschriebene Eigenschaftsprofil aufweisen. Beispiele gut geeigneter Poly(vinylalkohol-alkancarbonsäureester) sind Polyvinylacetat, -propionat oder -butyrat.

Die Bindemittel (a₁) und ihre Herstellung sind an sich bekannt und gehen beispielsweise aus dem eingangs genannten Stand der Technik hervor.

Das neuartige Bindemittelgemisch (A) enthält, bezogen auf seine Gesamtmenge, 20 bis 80 Gew.-% mindestens eines Bindemittels (a₂). Höhere oder niedrigere Anteile an Bindemittel (a₂) in dem neuartigen Bindemittelgemisch (A) sind für den Zweck der vorliegenden Erfindung nicht geeignet, denn sie führen zu einer Verschlechterung des Eigenschaftsprofils des betreffenden Bindemittelgemischs und des betreffenden photopolymerisierbaren Gemischs, so daß diese für die Zwecke der vorliegenden Erfindung nicht mehr länger tauglich sind. Demnach handelt es sich bei dem Mengenbereich von 20 bis 80 Gew.-% um ein Optimum, innerhalb dessen der Anteil des Bindemittels (a₂) an dem neuartigen Bindemittelgemisch (A) frei gewählt und dem jeweiligen Verwendungszweck des erfindungsgemäßen photopolymerisierbaren Gemischs in hervorragender Weise angepaßt werden kann. Innerhalb dieses Mengenbereichs ist derjenige von 25 bis 56 Gew.-% besonders hervorzuheben, weil aus der Verwendung dieser Mengen an Bindemittel (a₂) besonders vorteilhafte Bindemittelgemische (A) und erfindungsgemäße Gemische resultieren, welche sich leicht herstellen lassen und vorzügliche photopolymerisierbare Aufzeichnungsschichten, lichtempfindliche Aufzeichnungselemente und Hochdruckplatten liefern.

Bei dem Bindemittel (a₂) handelt es sich um ein partiell verseiftes Pfropfmischpolymerisat aus Vinylalkohol-alkancarbonsäureestern und Alkylenoxiden. Beispiele geeigneter Vinylalkohol-alkancarbonsäureester sind Vinylacetat, -propionat oder -butyrat, von denen Vinylacetat bevorzugt wird. Beispiele geeigneter Alkylenoxide sind Ethylenoxid und Propylenoxid, von denen Ethylenoxid bevorzugt wird.

Der Verseifungsgrad der Bindemittel (a₂) beträgt mehr als 80 % der vorhandenen Alkancarbonsäureestergruppen. Niedrigere Verseifungsgrade sollen dagegen nicht verwendet werden, weil hierdurch die vorzügliche Wasserlöslichkeit des Bindemittels (a₂) leidet. Von besonderem Vorteil sind Verseifungsgrade von 82 bis 90, insbesondere 85 %, weil Bindemittel (a₂) eines solchen Verseifungsgrades besonders vorteilhafte anwendungstechnische Eigenschaften aufweisen.

Der Gehalt des Bindemittels (a₂) an Alkylenoxid-Einheiten liegt, bezogen auf das Bindemittel (a₂), bei 10 bis 40 Gew.-%. Die Verwendung von geringeren oder höheren Mengen an Alkylenoxid-Einheiten ist zwar möglich, sie ist indes nicht zu empfehlen, weil hierdurch ein Eigenschaftsprofil resultiert, welches dem erfindungsgemäßen Verwendungszweck der Bindemittel (a₂) nicht mehr länger optimal angepaßt ist. Demnach handelt es sich bei dem Mengenbereich von 10 bis 40 Gew. -% um ein Optimum, innerhalb dessen der Gehalt der Bindemittel (a₂) an Alkylenoxid-Einheiten frei gewählt, und dem jeweiligen Verwendungszweck der photopolymerisierbaren Gemische in hervorragender Weise angepaßt werden kann. Innerhalb dieses Mengenbereichs ist derjenige von 20 bis 30 Gew.-% besonders hervorzuheben, weil Bindemittel (a₂) eines solchen Gehalts an Alkylenoxid-Einheiten bei der Herstellung und Verwendung besondere Vorteile zeigen.

Die Bindemittel (a₂) haben einen massenmittleren Polymerisationsgrad $\overline{P}_w$ von 300 bis 500, welcher in üblicher und bekannter Weise aus den durch Viskositätsmessungen an verdünnten Lösungen ermittelten massenmittleren Molekulargewichten $\overline{M}_w$ nach der Gleichung

$$\overline{M}_w = \overline{P}_w (86 - 0{,}42 \cdot \text{Verseifungsgrad})$$

errechnet wird. Die Verwendung von Bindemitteln (a₂) eines anderen massenmittleren Polymerisationsgrades $\overline{P}_w$ ist nicht zu empfehlen, weil hierdurch Bindemittelmischungen und photopolymerisierbare Gemische resultieren, welche die Vorteile der erfindungsgemäßen Gemische nicht mehr länger aufweisen. Demnach handelt es sich bei dem Bereich von 300 bis 500 um ein Optimum, innerhalb dessen der massenmittlere Polymerisationsgrad $\overline{P}_w$ frei gewählt und dem jeweiligen Verwendungszweck der erfindungsgemäßen Gemische angepaßt werden kann. Innerhalb dieses Bereichs ist derjenige von 440 bis 480 hervorzuheben, weil die Bindemittel (a₂) dieses massenmittleren Polymerisationsgrades $\overline{P}_w$ besonders vorteilhafte Eigenschaften aufweisen und daher erfindungsgemäß besonders bevorzugt verwendet werden.

Für das neuartige Bindemittelgemisch (A) ergeben sich zusätzliche Vorteile, wenn es, bezogen auf seine Gesamtmenge, bis zu 60, insbesondere bis zu 50 Gew.-% des Bindemittels (a₃) enthält. Die Verwendung größerer Mengen des Bindemittels (a₃) ist nicht zu empfehlen, denn hierdurch resultieren unvorteilhafte Bindemittelmischungen und photopolymerisierbare Gemische.

Das Bindemittel ($a_3$) unterscheidet sich von dem Bindemittel ($a_1$) in seinem Verseifungsgrad und seinem zahlenmittleren Polymerisationsgrad $\overline{P}_n$. So liegt der Verseifungsgrad des Bindemittels ($a_3$) oberhalb 75 % der ursprünglich vorhandenen Alkancarbonsäuregruppen, wobei Verseifungsgrade von weniger als 75 % nicht geeignet sind. Zusätzliche Vorteile ergeben sich, wenn das Bindemittel ($a_3$) einen Verseifungsgrad von mehr als 78 % aufweist. Der zahlenmittlere Polymerisationsgrad $\overline{P}_n$ des Bindemittels ($a_3$) soll bei 350 bis 450 liegen. Die Verwendung von Bindemitteln ($a_3$) mit anderen zahlenmittleren Polymerisationsgraden $\overline{P}_n$ ist dagegen von Nachteil. Mit besonderem Vorteil können diejenigen Bindemittel ($a_3$) mitverwendet werden, welche einen zahlenmittleren Polymerisationsgrad $\overline{P}_n$ um 400 aufweisen.

Auch die Eigenschaften und die Herstellung der Bindemittel ($a_2$) und ($a_3$) sind bekannt und gehen beispielsweise aus dem eingangs genannten Stand der Technik hervor.

Das erfindungsgemäße Gemisch enthält, bezogen auf seine Gesamtmenge, 35 bis 44 Gew.-% mindestens eines Monomeren (B). Zwar können die Monomeren (B) auch in höheren oder niedrigeren Mengen in dem erfindungsgemäßen Gemisch enthalten sein, indes entsprechen dann die betreffenden photopolymerisierbaren Gemische nicht immer den an sie gestellten Erwartungen und Anforderungen. Es ist deshalb nicht zu empfehlen, diesen optimalen Mengenbereich zu verlassen. Innerhalb dieses optimalen Mengenbereichs ist derjenige von 41 bis 43 Gew.-% hervorzuheben, weil die erfindungsgemäßen Gemische eines solchen Gehalts an Monomeren (B) sich besonders leicht zu den photopolymerisierbaren Aufzeichnungsschichten lichtempfindlicher Aufzeichnungselemente und Hochdruckplatten verarbeiten lassen.

Geeignete erfindungsgemäß zu verwendende Monomere (B) sind all die wasserlöslichen monofunktionellen ethylenisch ungesättigten photopolymerisierbaren Monomeren, welche mit dem neuartigen Bindemittelgemisch (A) verträglich sind.

Beispiele besonders gut geeigneter erfindungsgemäß zu verwendender Monomere (B) sind die Acrylsäure- und Methacrylsäuremonoester und die Alkencarbonylamino-N-methylenmonoether polyfunktioneller Alkohole wie Ethylenglykol, Glycerin, Diglycerin, Diethylenglykol, Triethylenglykol, Polyethylenglykol, Trimethylolethan oder Trimethylolpropan, von denen 2-Hydroxyethylacrylat und -methacrylat besonders bevorzugt sind.

Das erfindungsgemäße Gemisch enthält, bezogen auf seine Gesamtmenge, 6 bis 9 Gew.-% mindestens eines Monomeren (C). Zwar können geringere oder größere Mengen an Monomeren (C) verwendet werden, indes resultieren hierbei keine weiteren besonderen Vorteile, so daß sich eine solche Maßnahme nicht empfiehlt. Innerhalb des Mengenbereichs von 6 bis 9 Gew.-% ist derjenige von 7 bis 8 Gew.-% besonders hervorzuheben, weil die erfindungsgemäßen Gemische mit einem solchen Gehalt an Monomeren (C) in Herstellung und Verwendung besonders vorteilhaft sind.

Geeignete erfindungsgemäß zu verwendende Monomere (C) sind all die polyfunktionellen ethylenisch ungesättigten photopolymerisierbaren Monomere, welche mit dem neuartigen Bindemittelgemisch (A) verträglich sind. Hierbei sind diejenigen Monomere (C) gut geeignet, welche in Wasser löslich oder zumindest leicht dispergierbar sind.

Beispiele besonders gut geeigneter Monomerer (C) sind die polyfunktionellen Acrylate oder Methacrylate mit einem Molekulargewicht von nicht mehr als 2000 mit mindestens 2 Acryloyl- oder Methacryloylgruppen in ein und demselben Molekül und einer Anzahl von Hydroxylgruppen, welche die Anzahl der Acryloyl- oder Methacryloylgruppen in ein und demselben Molekül nicht übersteigt. Insgesamt soll die Anzahl der Kohlenstoffatome in diesen Monomeren (C) bei 6 bis 40 liegen.

Beispiele ganz besonders gut geeigneter Monomerer (C) dieser Art sind Glyceroldiacrylat, Glyceroldimethacrylat, Trimethylolpropandiacrylat, Trimethylolpropandimethacrylat, Pentaerythritoldiacrylat, Pentaerythritoldimethacrylat, Pentaerythritoltriacrylat, Pentaerythritoltrimethacrylat, Trimethylolethandiacrylat, Trimethylolethandimethacrylat, Tetramethylolethantriacrylat und Tetramethylolethantrimethacrylat.

Weitere Beispiele für gut geeignete erfindungsgemäß zu verwendende Monomere (C) sind die polyfunktionellen Acrylate oder Methacrylate mit 2 bis 5 Acryloyl- oder Methacryloylgruppen und derselben Anzahl von Hydroxylgruppen im Molekül, welche

- Reaktionsprodukte von Glycidylethern mehrwertiger Alkohole mit 2 bis 30 Kohlenstoffatomen und 2 bis 5 Hydroxylgruppen im Molekül mit ethylenisch ungesättigten Carbonsäuren mit 3 bis 15 Kohlenstoffatomen im Molekül oder
- die Reaktionsprodukte eines ungesättigten Alkohols mit 4 bis 15 Kohlenstoffatomen im Molekül mit Glycidylethern polyfunktioneller Alkohole mit 2 bis 30 Kohlenstoffatomen und 2 bis 5 Hydroxylgruppen im Molekül

sind.

Beispiele besonders gut geeigneter erfindungsgemäß zu verwendender Monomerer (C) dieser Art sind aus der EP-A-0 081 964 bekannt.

Weitere Beispiele gut geeigneter Monomerer (C) sind Ethylenglykol-, Diethylenglykol-, Triethylengylkol-, Tetraethylenglykol- und Polyethylenglykol-di(meth)acrylat,Propandiol-di(meth)acrylat, 1,4-Butandiol-di(meth)-acrylat, 1,5-Pentandiol-di(meth)acrylat, 1,6-Hexandiol-di(meth)acrylat, 1,1,1-Trimethylolpropantri(meth)-acrylat, Pentaeryhtritoltetra(meth)acrylat,Divinylether wie 1,4-Butandiol-divinylether sowie die Alkencarbonylamino-N-methylenether mehrwertiger Alkohole wie Ethylenglykol-bis-, Propandiol-bis-, 1,4-Butandiol-bis-, Diethylenglykol-bis-, Glycerol-tris- und Pentaerythritol-tetrakis-(methacrylamido-N-methylenether) oder die entsprechenden Acrylamido-N-methylenether.

Das erfindungsgemäße Gemisch enthält, bezogen auf seine Gesamtmenge 0,4 bis 5, insbesondere 0,5 bis 2.0 Gew.-%, mindestens eines Photopolymerisationsinitiators (D). Wegen der besonderen vorteilhaften Eigenschaften, welche sich aus dem neuartigen Bindemittelgemisch (A) mit den vorstehend genannten Monomeren (B) und (C) ergeben, sind diese geringen Mengen an Photopolymerisationsinitiatoren (D) völlig ausreichend.

Beispiele geeigneter erfindungsgemäß zu verwendender Photopolymerisationsinitiatoren (D) sind Benzoin oder Benzoinderivate wie dessen Methyl-, Isopropyl-, N-Butyl- oder Isobutylether; symmetrisch oder unsymmetrisch substituierte Benzilacetale wie Benzildimethylacetal oder Benzil-1-methyl-1-ethyl-acetal;Acyldiarylphosphinoxide und Acylarylphosphinsäurederivate wie 2,6-Dimethoxybenzoyl-diphenylphosphinoxid, 2,4,6-Trimethylbenzoyl-diphenylphosphinoxid, 2,4,6-Trimethylbenzoyl-phenylphosphinsäure-natriumsalz oder 2,4,6-Trimethylbenzoyl-phenylphosphinsäure-ethylester; und substituierte und unsubstituierte Chinone wie Ethylanthrachinon, Benzanthrachinon, Benzophenon oder 4,4'-Bis-(dimethylamino)-benzophenon, welche allein oder im Gemisch miteinander verwendet werden können.

Darüber hinaus können die erfindungsgemäßen Gemische sonstige vom Stand der Technik her bekannte Polyvinylalkoholharze in untergeordneten Mengen, welche sich nicht auf das Eigenschaftsprofil der erfindungsgemäßen Gemische nachteilig auswirken, enthalten. Beispiele solcher Polyvinylalkoholharze gehen aus dem eingangs genannten Stand der Technik hervor.

Darüber hinaus können die erfindungsgemäßen Gemische noch weitere Zusatzstoffe wie Inhibitoren der thermischen Polymerisation, Weichmacher, Farbstoffe, Pigmente, photochrome Zusätze, Reduktionsmittel, Mittel zur Verbesserung der Reliefstruktur, Antioxidantien, Füllstoffe, Verstärkerfüllstoffe u.a. in wirksamen Mengen enthalten.

Die Herstellung der erfindungsgemäßen Gemische aus ihren Bestandteilen weist keine methodischen Besonderheiten auf, sondern es können die üblichen Knet-, Misch- und Lösungstechniken für die Vermischung der Bestandteile angewendet werden.

Die so erhaltenen erfindungsgemäßen Gemische können den unterschiedlichsten Anwendungszwecken zugeführt werden und zeigen hierbei ihre besonderen vorteilhaften Eigenschaften. Vor allem aber werden sie zur Herstellung von neuen lichtempfindlichen Aufzeichnungselementen verwendet. Hierzu werden sie in üblicher Weise durch Gießen aus einer Lösung, Heißpressen, Kalandrieren oder Extrudieren zu neuen Schichten der gewünschten Dicke geformt. Die Dicke dieser neuen Schichten richtet sich in erster Linie danach, ob sie in den neuen lichtempfindlichen Aufzeichnungselementen als neue photopolymerisierbare Aufzeichnungsschicht oder als neue photopolymerisierbare Haftschicht verwendet werden sollen. Die Dicke der neuen photopolymerisierbaren Aufzeichnungsschichten wiederum richtet sich nach dem Anwendungszweck der neuen lichtempfindlichen Aufzeichnungselemente und variiert im allgemeinen von 0,001 bis 0,8 mm, wogegen die neuen Haftschichten üblicherweise 0,0005 bis 0,1 mm dick sind.

Die neuen lichtempfindlichen Aufzeichnungselemente enthalten entweder mindestens eine neue photopolymerisierbare Aufzeichnungsschicht oder mindestens eine neue Haftschicht aus dem erfindungsgemäßen Gemisch. Von ganz besonderem Vorteil sind indes die neuen lichtempfindlichen Aufzeichnungselemente, deren neue photopolymerisierbare Aufzeichnungsschicht und Haftschicht aus dem erfindungsgemäßen Gemisch bestehen.

Üblicherweise ist die neue photopolymerisierbare Aufzeichnungsschicht in dem neuen lichtempfindlichen Aufzeichnungselement mit einem dimensionsstabilen Träger haftfest verbunden. Außerdem kann auf die dem Träger abgewandten Seite der neuen photopolymerisierbaren Aufzeichnungsschicht eine übliche und bekannte Deckschicht oder eine übliche und bekannte Deckfolie aufgebracht werden.

Werden Deckschicht und Deckfolie gemeinsam verwendet, dann liegt die Deckschicht der neuen photopolymerisierbaren Aufzeichnungsschicht direkt auf, und es kann sich zwischen Deckschicht und Deckfolie noch eine übliche und bekannte Antihaftschicht befinden. Ferner kann eine haftfeste Verbindung zwischen der neuen photopolymerisierbaren Aufzeichnungsschicht und der Deckfolie mit Hilfe einer Haftschicht erzielt werden.

Als dimensionsstabile Träger werden üblicherweise Platten, Folien oder Zylinderhülsen (sleeves) aus Metallen wie Stahl, Aluminium, Kupfer oder Nickel oder aus Hochpolymeren wie Polyethylenterephthalat, Polybutylenterephthalat, Polyamid oder Polycarbonat verwendet. Daneben kommen noch Gewebe und

8

Vliese wie Glasfasergewebe oder Verbundmaterialien aus beispielsweise Glasfasern und Hochpolymeren in Betracht.

Als Haftschichten können übliche und bekannte 0,0005 bis 0,1 mm dicke Haftschichten verwendet werden. Von Vorteil sind indes die neuen Haftschichten aus den erfindungsgemäßen Gemischen. Die Haftschichten werden entweder vor dem Auftragen der neuen photopolymerisierbaren Aufzeichnungsschicht durch eine vollflächige Belichtung durch Photopolymerisation oder durch eine Wärmebehandlung thermisch oder nach dem Auftragen der neuen photopolymerisierbaren Aufzeichnungsschicht durch Photopolymerisation vernetzt. Der Vernetzung vor dem Auftragen der neuen photopolymerisierbaren Aufzeichnungsschicht wird hierbei der Vorzug gegeben.

Übliche Deckschichten sind 0,5 bis 20 $\mu$m dick und können aus einem Polymeren bestehen, welches lösliche, klebfreie, transparente und reißfeste Filme bildet, z.B. Polyamid, Copolyamid, Polyurethan, Polyvinylalkoholharze der unterschiedlichsten Art, Polvinylpyrrolidon, Polyethylenoxid oder Cyclokautschuk. Gegebenenfalls kann die Deckschicht mattiert sein.

Übliche Deckfolien sind 20 bis 150 $\mu$m dick und bestehen aus einem Polymeren wie Polyamid oder Polyethylenterephthalat.

Übliche Antihaftschichten sind 0,1 bis 0,5 $\mu$m dick und bestehen beispielsweise aus Silikonharzen. Werden als Träger stark reflektierende Platten oder Folien verwendet, können sie übliche Lichthofschutzmittel wie Ruß oder Mangandioxid enthalten. Die Lichthofschutzmittel können aber auch als separate Schicht auf dem Träger aufliegen oder in der Haftschicht oder der neuen photopolymerisierbaren Aufzeichnungsschicht enthalten sein.

Die Herstellung der neuen lichtempfindlichen Aufzeichnungselemente weist keine methodischen Besonderheiten auf. Üblicherweise erfolgt sie durch Auftragen der neuen photopolymerisierbaren Aufzeichnungsschicht auf den mit einer neuen oder einer üblichen und bekannten Haftschicht versehenen Träger mittels Gießen aus Lösung, Heißpressen, Kalandrieren oder Extrudieren. Auf ein solches neues lichtempfindliches Aufzeichnungselement können dann die anderen Schichten in bekannter Weise aufgebracht werden. Es ist indes auch möglich, die neue photopolymerisierbare Aufzeichnungsschicht zunächst auf die mit einer Deckschicht bedeckten Seite einer Deckfolie aufzutragen und im Anschluß daran die unbedeckte Seite der neuen photopolymerisierbaren Aufzeichnungsschicht mit dem Träger haftfest zu verbinden.

Aus diesen neuen lichtempfindlichen Aufzeichnungselementen können in üblicher und bekannter Weise durch Photopolymerisation Hochdruckplatten, insbesondere Zeitungsdruckplatten, hergestellt werden. Die Herstellung bietet methodisch keine Besonderheiten, sondern erfolgt - gegebenenfalls im Anschluß an eine Vorbehandlung - durch bildmäßiges Belichten der neuen lichtempfindlichen Aufzeichnungselemente mit aktinischem Licht einer Wellenlänge $\lambda$ zwischen 300 und 450 nm, vorteilhafterweise 320 und 400 nm, durch aufgelegte Negativ-Vorlagen hindurch, Auswaschen der unbelichteten und daher nicht photopolymerisierten Bereiche der bildmäßig belichteten neuen lichtempfindlichen Aufzeichnungselemente mit Wasser oder üblichen und bekannten wäßrigen Lösungen und Trocknen der in dieser Weise erhaltenen Hochdruckplatten, welche nun eine Reliefschicht enthalten.

Übliche Vorbehandlungen sind beispielsweise das Abziehen einer gegebenenfalls in dem neuen lichtempfindlichen Aufzeichnungselement vorhandenen Deckfolie oder die vollflächige Belichtung der neuen photopolymerisierbaren Aufzeichnungsschicht und/oder der neuen oder üblichen und bekannten Haftschicht mit aktinischem Licht von der Rückseite her, d.h. von derjenigen Seite her, die später der druckenden Fläche abgewandt ist.

Geeignete Lichtquellen für aktinisches Licht sind z.B. handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen sowie Laserlicht.

Eine übliche Nachbehandlung ist das vollflächige Nachbelichten der Hochdruckplatten mit aktinischem Licht.

Die Dicke der Reliefschicht der in dieser Weise erhaltenen Hochdruckplatten variiert je nach Verwendungszweck von 0,001 bis 0,8 mm.

Die in dieser Weise erhaltenen Hochdruckplatten können in üblicher und bekannter Weise auf Druckzylinder aufgespannt und für den Endloshochdruck, insbesondere den Zeitungsdruck, verwendet werden.

Die erfindungsgemäßen Gemische weisen bei ihrer Herstellung, Verarbeitung und Verwendung gegenüber dem Stand der Technik besondere unerwartete Vorteile auf. So sind bei ihrer Herstellung keine besonderen Maßnahmen zu ergreifen, sondern es können die für solche Gemische üblichen und bekannten Herstellmethoden verwendet werden. Hierbei lassen sich die erfindungsgemäßen Gemische in besonders hohen Konzentrationen in Wasser auflösen, was den Energieverbrauch bei ihrer Herstellung und Weiterverarbeitung drastisch verringert. Aufgrund ihrer hohen thermischen Stabilität lassen sich die erfindungsgemäßen Gemische sehr leicht nach den üblichen Verfahren zu den unterschiedlichsten Produkten verarbeiten, ohne daß hierzu besondere Vorsichtsmaßnahmen zu ergreifen sind. Sie sind von hervorragender Lagerstabilität und sie lassen sich umweltfreundlich entsorgen, was in der betrieblichen Praxis von großem Vorteil ist.

Die neuen lichtempfindlichen Aufzeichnungselemente, welche die neuen photopolymerisierbaren Aufzeichnungsschichten aus den erfindungsgemäßen Gemischen enthalten, zeigen gleichfalls besondere unerwartete technische Effekte.

So haben ihre neuen photopolymerisierbaren Aufzeichnungsschichten eine klebfreie Oberfläche, so daß sich das Auflegen und das Abnehmen der Negativ-Vorlagen problemlos durchführen läßt. Die neuen photopolymerisierbaren Aufzeichnungsschichten sind nicht mehr länger spröde und weisen eine hohe Kohäsion auf, so daß sie bei der Lagerung keine Risse mehr bilden. Auch nach langer Lagerung bei höheren Temperaturen, wie sie beispielsweise im Hochsommer oder in tropischen Gebieten auftreten, zeigen die neuen photopolymerisierbaren Aufzeichnungsschichten keinerlei Trübungen und kein Ausschwitzen ihrer Bestandteile. Sie lassen sich besonders rasch bildmäßig mit aktinischem Licht belichten und weisen hierbei eine besonders hohe Auflösung und einen besonders hohen Belichtungsspielraum auf. Besonders hervorzuheben sind ihre kurzen Auswaschzeiten. Wegen der besonders guten Löslichkeit der nicht photopolymerisierten Bereiche der neuen photopolymerisierten Aufzeichnungsschichten tritt auch keine Verschmutzung der für ihre Entwicklung verwendeten Wascher mehr auf.

Die aus den neuen lichtempfindlichen Aufzeichnungselementen erhaltenen Hochdruckplatten, insbesondere Zeitungsdruckplatten, haben eine besonders gleichmäßige und glatte Oberfläche, was zu einer deutlich verbesserten vollflächigen Farbdeckung im Druck führt. Ihre Reliefschichten haben sehr glatte Flanken, wodurch ihre Neigung zum "linting" beim Drucken deutlich verringert ist. Insgesamt resultiert ein gegenüber dem Stand der Technik deutlich verbessertes Druckverhalten und eine höhere Auflagenfestigkeit.

Überraschenderweise können die erfindungsgemäßen Gemische nicht nur in den neuen photopolymerisierbaren Aufzeichnungsschichten der neuen lichtempfindlichen Aufzeichnungselemente verwendet werden, sondern auch in den darin enthaltenen Haftschichten. Auch in dieser Funktion manifestieren sich die besonderen unerwarteten Vorteile der erfindungsgemäßen Gemische. So hat die Verwendung der neuen Haftschichten in den neuen lichtempfindlichen Aufzeichnungselementen eine Verbesserung der Quellbeständigkeit, der Wasserbeständigkeit, der Dimensionsstabilität, der Farbfestigkeit und der Abriebfestigkeit in den hieraus hergestellten Hochdruckplatten zur Folge, so daß es u.a. auch bei sehr hohen Druckauflagen nicht zum Ablösen von Reliefteilen kommt.

Ganz besondere Vorteile ergeben sich, wenn man die erfindungsgemäßen Gemische für die Herstellung der neuen Haftschichten und der neuen photopolymerisierbaren Aufzeichnungsschichten verwendet. Dadurch resultieren neue lichtempfindliche Aufzeichnungselemente, in welchen sich die vorstehend genannten besonderen technischen Effekte gegenseitig verstärken. Hierbei ist vor allem die in der Praxis äußerst hinderliche Überwaschempfindlichkeit bekannter lichtempfindlicher Aufzeichnungselemente zu nennen, welche bei den neuen lichtempfindlichen Aufzeichnungselementen nicht mehr auftritt.

Die Vorteile der erfindungsgemäßen Gemische werden im folgenden anhand ihrer Verwendung zur Herstellung von neuen lichtempfindlichen Aufzeichnungselementen näher erläutert.

Beispiel 1

Herstellung eines neuen lichtempfindlichen Aufzeichnungselements mit einer neuen photopolymerisierbaren Aufzeichnungsschicht aus einem erfindungsgemäßen Gemisch; Herstellvorschrift:

250 g eines Polyvinylacetats mit einem zahlenmittleren Polymerisationsgrad $\overline{P}_n$ von 300 und einem Verseifungsgrad von 83 % sowie 250 g eines Vinylalkohol/Ethylenoxid-Pfropfmischpolymerisats eines Gehalts an Ethylenoxid-Einheiten von 25 Gew.-%, eines Verseifungsgrades von 85 % und eines massenmittleren Polymerisationsgrades $\overline{P}_w$ von ca. 460 wurden während 30 Minuten bei 90°C in 270 g destilliertem Wasser gelöst. Im Anschluß daran wurden 400 g 2-Hydroxyethylmethacrylat, 80 g 1,4-Butandioldimethacrylat, 9 g 2,4,6-Trimethylphenylbenzoyl-diphenylphosphinoxid, 3 g Kerobit TBK (2,6-Di-tert.-butyl-p-kresol) sowie 0,024 g Duasyn Basisch Rot TH (C.I. 50240) zu der Lösung hinzugegeben. Die so erhaltene Gießlösung wurde dann auf ein mit einem Lichthofschutzlack versehenes Stahlblech gegossen, wonach die resultierende Naßschicht ohne jegliche Rißbildung unter Erhalt einer 500 $\mu$m neuen photopolymerisierbaren Aufzeichnungsschicht getrocknet wurde.

Nach der bildmäßigen Belichtung, der Entwicklung mit Wasser und dem Trocknen des neuen lichtempfindlichen Aufzeichnungselements wurde eine Hochdruckplatte mit einer 500 $\mu$m dicken Reliefschicht erhalten.

Die vorteilhaften anwendungstechnischen Eigenschaften des neuen lichtempfindlichen Aufzeichnungselements und der hieraus hergestellten Hochdruckplatte gehen aus der Tabelle hervor.

Beispiel 2

Herstellung eines neuen lichtempfindlichen Aufzeichnungselements mit einer neuen photopolymerisierbaren Aufzeichnungsschicht aus einem erfindungsgemäßen Gemisch; Herstellvorschrift:
175 g eines Polyvinylacetats mit einem zahlenmittleren Polymerisationsgrad $\overline{P}_n$ von 300 und einem Verseifungsgrad von 82 %, 175 g eines Polyvinylacetats mit einem zahlenmittleren Polymerisationsgrad $\overline{P}_n$ von 400 und einem Verseifungsgrad von 80 % sowie 145 g des Pfropfmischpolymerisats gemäß Beispiel 1 wurden während 30 Minuten in 300 g destilliertem Wasser gelöst. Im Anschluß daran wurden 400 g 2-Hydroxyethylacrylat, 75 g 1,4-Butandioldimethacrylat, 8 g 2,4,6-Trimethylbenzoyl-diphenylphosphinoxid, 3 g Kerobit TBK und 0,02 g Duasyn Basisch Rot TH hinzugefügt. Die resultierende Gießlösung wurde wie in Beispiel 1 beschrieben zu einem neuen lichtempfindlichen Aufzeichnungselement und hiernach zu einer Hochdruckplatte weiterverarbeitet.
Die vorteilhaften anwendungstechnischen Eigenschaften des so erhaltenen neuen lichtempfindlichen Aufzeichnungselements und der hieraus hergestellten Hochdruckplatte gehen gleichfalls aus der Tabelle hervor.

Vergleichsversuch

Herstellung eines bekannten lichtempfindlichen Aufzeichnungselements mit einer bekannten photopolymerisierbaren Aufzeichnungsschicht aus einem bekannten photopolymerisierbaren Gemisch; Herstellvorschrift:
Nach dem in den Beispielen 1 und 2 beschriebenen Verfahren wurde eine bekannte Hochdruckplatte hergestellt, nur daß anstelle der dort verwendeten erfindungsgemäßen Gemische das nicht erfindungsgemäße Gemisch aus 161 g eines Polyvinylacetats mit einem zahlenmittleren Polymerisationsgrad $\overline{P}_n$ von 500 und einem Verseifungsgrad von 82 %, 161 g des Polyvinylacetats mit einem zahlenmittleren Polymerisationsgrad $\overline{P}_n$ von 400 gemäß Beispiel 2, 138 g des Pfropfmischpolymerisats gemäß Beispiel 1, 350 g destilliertem Wasser, 380 g 2-Hydroxyethylmethacrylat, 80 g Cetamoll BMB (N-(n-Butyl)-benzolsulfonsäureamid), 8 g 2,4,6-Trimethylbenzoyl-diphenylphosphinoxid und 0,3 g Kerobit TBK verwendet wurde. Hierbei zeigte es sich, daß für das Auflösen der Polyvinylalkoholharze in Wasser eine Stunde aufgewandt werden mußte, was mehr als doppelt so lang war wie bei den Beispielen 1 und 2.
Die anwendungstechnischen Eigenschaften des bekannten lichtempfindlichen Aufzeichnungselements und der hieraus hergestellten Hochdruckplatten werden in der Tabelle den weitaus vorteilhafteren anwendungstechnischen Eigenschaften der neuen lichtempfindlichen Aufzeichnungselemente und Hochdruckplatten der Beispiele 1 und 2 gegenübergestellt.
Der Vergleich der in der Tabelle angegebenen Werte zeigt, daß die mit dem erfindungsgemäßen Gemisch erzielte Verbesserung gegenüber dem Stand der Technik im Mittel bei etwa 57 % lag, was den besonderen unerwarteten technischen Effekt des erfindungsgemäßen Gemischs ganz besonders deutlich macht.

Tabelle

Die anwendungstechnischen Eigenschaften der neuen lichtempfindlichen Aufzeichnungselemente und Hochdruckplatten (Beispiele 1 und 2) im Vergleich mit dem bekannten Aufzeichnungselement und der bekannten Hochdruckplatte (Vergleichsversuch)

| Parameter | lichtempfindliches Aufzeichnungselement und Hochdruckplatte des | | |
| --- | --- | --- | --- |
| | Beispiels 1 | Beispiels 2 | Vergleichsversuchs |
| lichtempfindliches Element: | | | |
| Vorbelichtungszeit (s)[1] | 2,5 | 2,3 | 2,8 |
| Hauptbelichtungszeit (s)[2] | 22 | 18 | 30 |
| Auswaschzeit (s)[3] | 70 | 80 | 130 |
| Hochdruckplatte: | | | |
| Zwischentiefen ($\mu$m): | | | |
| Raster des Tonwertes 30%[4] | 201 | 193 | 110 |
| Raster des Tonwertes 50 % | 165 | 167 | 84 |
| Raster des Tonwertes 70 % | 125 | 121 | 55 |
| Druckverhalten | excellent, sehr hohe Auflage | excellent, sehr hohe Auflage | gut, übliche Auflage |

[1]   vollflächige Belichtung mit einem Quecksilberniederdruckbrenner der Fa. Theimer (5 kW)
[2]   bildmäßige Belichtung mit einem Quecksilberniederdruckbrenner der Fa. Theimer (5 kW)
[3]   Sprühwascher, Wasserdruck 4 bar
[4]   32 Linien/cm

Patentansprüche

1. Wasserlösliches oder -dispergierbares photopolymerisierbares Gemisch, welches, bezogen auf seine Gesamtmenge,

A) 46 bis 53 Gew.-% eines Bindemittels aus, bezogen auf das Bindemittel (A)

EP 0 415 187 B1

a$_1$) 20 bis 80 Gew.-% mindestens eines Poly(vinylalkohol-alkancarbonsäureesters) mit einem Verseifungsgrad von 75 bis 85 % der ursprünglich vorhandenen Alkancarbonsäureestergruppen und einem zahlenmittleren Polymerisationsgrad $\overline{P}_n$ von 250 bis 350,

a$_2$) 20 bis 80 Gew.-% mindestens eines partiell verseiften Pfropfmischpolymerisats aus Vinylalkohol-alkancarbonsäureestern und Alkylenoxiden mit einem Verseifungsgrad von mehr als 80 % der ursprünglich vorhandenen Alkancarbonsäureestergruppen, einem Gehalt an Alkylenoxid-Einheiten von 10 bis 40 Gew.-% und einem aus dem durch Viskositätsmessungen an verdünnten Lösungen ermittelten massenmittleren Molgewicht $\overline{M}_w$ nach der Gleichung

$$\overline{M}_w = \overline{P}_w (86 - 0,42 \cdot \text{Verseifungsgrad})$$

errechneten massenmittleren Polymerisationsgrad $\overline{P}_w$ von 300 bis 500 und

a$_3$) 0 bis 60 Gew.-% mindestens eines partiell verseiften Poly(vinylalkohol-alkancarbonsäureesters) mit einem Verseifungsgrad von mehr als 75 % der ursprünglich vorhandenen Alkancarbonsäureestergruppen und einem zahlenmittleren Polymerisationsgrad $\overline{P}_n$ von 350 bis 450,

B) 35 bis 44 Gew.-% mindestens eines wasserlöslichen monofunktionellen ethylenisch ungesättigten photopolymerisierbaren Monomeren, welches mit dem Bindemittel (A) verträglich ist,

C) 6 bis 9 Gew.-% mindestens eines polyfunktionellen ethylenisch ungesättigten photopolymerisierbaren Monomeren, welches mit dem Bindemittel (A) verträglich ist, und

D) 0,4 bis 5 Gew.-% mindestens eines Photopolymerisationsinitiators enthält.

2. Das photopolymerisierbare Gemisch nach Anspruch 1, dadurch gekennzeichnet, daß das Bindemittel (A), bezogen auf seine Gesamtmenge, 5 bis 40 Gew.-% des partiell verseiften Poly(vinylalkohol-alkancarbonsäureesters) (a$_3$) enthält.

3. Das photopolymerisierbare Gemisch nach Anspruch 1 oder 2, dadurch gekennzeichnet, daß der Verseifungsgrad des partiell verseiften Poly(vinylalkohol-alkancarbonsäureesters) (a$_1$) bei 78 bis 83 % liegt.

4. Das photopolymerisierbare Gemisch nach einem der Ansprüche 1 bis 3, dadurch gekennzeichnet, daß der zahlenmittlere Polymerisationsgrad $\overline{P}_n$ des partiell verseiften Poly(vinylalkohol-alkancarbonsäureesters) (a$_1$) bei 300 liegt.

5. Das photopolymerisierbare Gemisch nach einem der Ansprüche 1 bis 4, dadurch gekennzeichnet, daß der Verseifungsgrad des partiell verseiften Poly(vinylalkohol-alkancarbonsäureesters) (a$_2$) bei 85 % liegt.

6. Das photopolymerisierbare Gemisch nach einem der Ansprüche 1 bis 5, dadurch gekennzeichnet, daß der Gehalt an Alkylenoxid-Einheiten des Pfropfmischpolymerisats (a$_2$) bei 20 bis 30 Gew.-%, bezogen auf das Mischpolymerisat, liegt.

7. Das photopolymerisierbare Gemisch nach einem der Ansprüche 1 bis 6, dadurch gekennzeichnet, daß der massenmittlere Polymerisationsgrad $\overline{P}_w$ des Pfropfmischpolymerisats (a$_2$) bei 400 bis 500 liegt.

8. Das photopolymerisierbare Gemisch nach einem der Ansprüche 1 bis 7, dadurch gekennzeichnet, daß der Verseifungsgrad des partiell verseiften Poly(vinylalkohol-alkancarbonsäureesters) (a$_3$) oberhalb 80 % liegt.

9. Das photopolymerisierbare Gemisch nach einem der Ansprüche 1 bis 8, dadurch gekennzeichnet, daß der zahlenmittlere Polymerisationsgrad $\overline{P}_n$ des partiell verseiften Poly(vinylalkohol-alkancarbonsäureesters) (a$_3$) bei 400 liegt.

10. Verwendung des photopolymerisierbaren Gemischs gemäß einem der Ansprüche 1 bis 9 für die Herstellung von lichtempfindlichen Aufzeichnungselementen.

**11.** Lichtempfindliche Aufzeichnungselemente, welche einen Träger und mindestens eine photopolymerisierbare Aufzeichnungsschicht enthalten, dadurch gekennzeichnet, daß die photopolymerisierbare(n) Aufzeichnungsschicht(en) aus einem photopolymerisierbaren Gemisch gemäß einem der Ansprüche 1 bis 9 besteht oder bestehen.

**12.** Lichtempfindliche Aufzeichnungselemente, welche einen Träger, eine Haftschicht und mindestens eine photopolymerisierbare Aufzeichnungsschicht enthalten, dadurch gekennzeichnet, daß die Haftschicht und/oder mindestens eine der photopolymerisierbaren Aufzeichnungsschichten aus einem photopolymerisierbaren Gemisch gemäß einem der Ansprüche 1 bis 9 besteht oder bestehen.

**13.** Verwendung der lichtempfindlichen Aufzeichnungselemente gemäß Anspruch 11 oder 12 für die Herstellung von Zeitungsdruckplatten.

**Claims**

**1.** A water-soluble or water-dispersible photopolymerizable mixture, comprising the following components:
A) from 46 to 53% by weight, based on the total weight of the mixture, of a binder consisting of
$a_1$) from 20 to 80% by weight, based on the total weight of the binder, of one or more polyvinyl alkanecarboxylates having a degree of hydrolysis of from 75 to 85% of the alkanecarboxylate groups originally present and a number average degree of polymerization $\overline{P}_n$ of from 250 to 350,
$a_2$) from 20 to 80% by weight, based on the total weight of the binder, of one or more partially hydrolyzed graft copolymers of vinyl alkanecarboxylates and alkylene oxides having a degree of hydrolysis of more than 80% of the alkanecarboxylate groups originally present, containing from 10 to 40% by weight of alkylene oxide units and possessing a weight average degree of polymerization $\overline{P}_w$ of from 300 to 500, calculated from the weight average molecular weight $\overline{M}_w$ determined by viscosity measurements using dilute solutions, in accordance with the equation

$$\overline{M}_w = \overline{P}_w \, (86 - 0.42 \cdot \text{degree of hydrolysis}),$$

and
$a_3$) from 0 to 60% by weight, based on the total weight of the binder, of one or more partially hydrolyzed polyvinyl alkanecarboxylates having a degree of hydrolysis of more than 75% of the alkanecarboxylate groups originally present and a number average degree of polymerization $\overline{P}_n$ of from 350 to 450,
B) from 35 to 44% by weight, based on the total weight of the mixture, of one or more water-soluble monofunctional ethylenically unsaturated photopolymerizable monomers which are compatible with the binder (A),
C) from 6 to 9% by weight, based on the total weight of the mixture, of one or more polyfunctional ethylenically unsaturated photopolymerizable monomers which are compatible with the binder (A), and
D) from 0.4 to 5% by weight, based on the total weight of the mixture, of one or more photopolymerization initiators.

**2.** A photopolymerizable mixture as claimed in claim 1, wherein the binder (A) contains from 5 to 40% by weight, based on the total amount of the binder, of the partially hydrolyzed polyvinyl alkanecarboxylate ($a_3$).

**3.** A photopolymerizable mixture as claimed in claim 1 or 2, wherein the degree of hydrolysis of partially hydrolyzed polyvinyl alkanecarboxylate ($a_1$) is from 78 to 83%.

**4.** A photopolymerizable mixture as claimed in any of claims 1 to 3, wherein the number average degree of polymerization $\overline{P}_n$ of the partially hydrolyzed polyvinyl alkanecarboxylate ($a_1$) is 300.

**5.** A photopolymerizable mixture as claimed in any of claims 1 to 4, wherein the degree of hydrolysis of the partially hydrolyzed polyvinyl alkanecarboxylate ($a_2$) is 85%.

**6.** A photopolymerizable mixture as claimed in any of claims 1 to 5, wherein the content of alkylene oxide units in the graft copolymer ($a_2$) is from 20 to 30% by weight, based on the copolymer.

**7.** A photopolymerizable mixture as claimed in any of claims 1 to 6, wherein the weight average degree of polymerization $\overline{P}_w$ of the graft copolymer ($a_2$) is from 400 to 500.

**8.** A photopolymerizable mixture as claimed in any of claims 1 to 7, wherein the degree of hydrolysis of the partially hydrolyzed polyvinyl alkanecarboxylate ($a_3$) is greater than 80%.

**9.** A photopolymerizable mixture as claimed in any of claims 1 to 8, wherein the number average degree of polymerization $\overline{P}_n$ of the partially hydrolyzed polyvinyl alkanecarboxylate ($a_3$) is 400.

**10.** Use of a photopolymerizable mixture as claimed in any of claims 1 to 9 for the production of photosensitive recoding elements.

**11.** A photosensitive recording element which contains a substrate and at least one photopolymerizable recording layer, wherein the photopolymerizable recording layer or layers consists or consist of a photopolymerizable mixture as claimed in any of claims 1 to 9.

**12.** A photosensitive recording element which contains a substrate, an adhesive layer and at least one photopolymerizable recording layer, wherein the adhesive layer and/or at least one of the photopolymerizable recording layers consists or consist of a photopolymerizable mixture as claimed in any of claims 1 to 9.

**13.** Use of a photosensitive recording element as claimed in claim 11 or 12 for the production of newspaper printing plates.

**Revendications**

**1.** Mélange photopolymérisable soluble ou dispersable dans l'eau, contenant, sur son poidS total,
A) 46 à 53 % en poids d'un liant consistant lui-même, sur son poids total, en
a1) 20 à 80 % en poids d'au moins un poly-(ester alcanoïque de l'alcool vinylique) d'un taux de saponification de 75 à 85 % des groupes ester alcanïque présents à l'origine et d'un degré de polymérisation moyen, moyenne en nombre, $P_n$ de 250 à 350,
a2) 20 à 80 % en poids d'au moins un copolymère greffé d'esters alcanoïques de l'alcool vinylique et d'oxydes d'alkylène, partiellement saponifié, d'un taux de saponification supérieur à 80 % des groupes ester alcanoïque présents à l'origine, une teneur en motifs oxyde d'alkylène de 10 à 40 % en poids et un degré de polymérisation moyen, moyenne en poids, $\overline{P}_w$, calculé à partir du poids moléculaire moyen, moyenne en poids, $\overline{M}_w$, lui-même déterminé par des mesures de viscosité en solution diluée, d'après l'équation

$$\overline{M}_w = \overline{P}_w(86\text{-}0,42. \text{ degré de saponification})$$

de 300 à 500, et
a3) 0 à 60 % en poids d'au moins un poly-(ester alcanoïque de l'alcool vinylique) partiellement saponifié, d'un taux de saponification supérieur à 75 % des groupes ester alcanoïque présents à l'origine et d'un degré de polymérisation moyen, moyenne en nombre, $\overline{P}_n$ de 350 à 450,
B) 35 à 44 % en poids d'au moins un monomère monofonctionnel à insaturation éthylénique, photopolymérisable, soluble dans l'eau, compatible avec le liant A),
C) 6 à 9 % en poids d'au moins un monomère à insaturation éthylénique, photopolymérisable, polyfonctionnel, compatible avec le liant A), et
D) 0,4 à 5 % en poids d'au moins un inducteur de photopolymérisation.

**2.** Le mélange photopolymérisable selon la revendication 1, caractérisé en ce que le liant A) contient, sur son poids total, 5 à 40 % en poids du poly-(ester alcanoïque d'alcool vinylique) partiellement saponifié a3).

**3.** Le mélange photopolymérisable selon la revendication 1 ou 2, caractérisé en ce que le taux de saponification du poly-(ester alcanoïque d'alcool vinylique) partiellement saponifié a1) est de 78 à 83 %.

**4.** Le mélange photopolymérisable selon une des revendications 1 à 3, caractérisé en ce que le degré de polymérisation moyen, moyenne en nombre, $\overline{P}_n$ du poly-(ester alcanoïque d'alcool vinylique) partiellement saponifié a1) est de 300.

**5.** Le mélange photopolymérisable selon une des revendications 1 à 4, caractérisé en ce que le taux de saponification du poly-(ester alcanoïque d'alcool vinylique) partiellement saponifié a2) est de 85 %.

**6.** Le mélange photopolymérisable selon une des revendications 1 à 5, caractérisé en ce que la teneur en motifs oxyde d'alkylène du copolymère greffé a2) est de 20 à 30 % du poids du copolymère.

**7.** Le mélange photopolymérisable selon une des revendications 1 à 6, caractérisé en ce que le degré de polymérisation moyen, moyenne en poids, $\overline{P}_w$ du copolymère greffé a2) est de 400 à 500.

**8.** Le mélange photopolymérisable selon une des revendications 1 à 7, caractérisé en ce que le taux de saponification du poly-(ester alcanoïque d'alcool vinylique) partiellement saponifié a3) est supérieur à 80 %.

**9.** Le mélange photopolymérisable selon une des revendications 1 à 8, caractérisé en ce que le degré de polymérisation moyen, moyenne en nombre, $\overline{P}_n$ du poly-(ester alcanoïque d'alcool vinylique) partiellement saponifié a3) est de 400.

**10.** Utilisation du mélange photopolymérisable selon une des revendications 1 à 9 pour la fabrication d'éléments d'enregistrement photosensibles.

**11.** Eléments d'enregistrement photosensibles contenant un support et au moins une couche d'enregistrement photopolymérisable, caractérisée en ce que la ou les couches d'enregistrement photopolymérisables consistent en un mélange photopolymérisable selon une des revendications 1 à 9.

**12.** Eléments d'enregistrement photosensibles contenant un support, une couche d'adhérence et au moins une couche d'enregistrement photopolymérisable, caractérisés en ce que la couche d'adhérence et/ou au moins une des couches d'enregistrement photopolymérisables consistent en un mélange photopolymérisable selon une des revendication 1 à 9.

**13.** Utilisation des éléments d'enregistrement photosensibles selon la revendication 1 ou 12 pour la fabrication de plaques d'impression de journaux.